# EUROPEAN PATENT APPLICATION

(11) **EP 2 479 805 A1**
(43) Date of publication of application: **25.07.2012**
(21) Application number: 10817131.5
(22) Date of filing: 13.09.2010
(51) Int. Cl.: H01L 33/30

(54) **LIGHT EMITTING DIODE, LIGHT EMITTING DIODE LAMP, AND ILLUMINATING APPARATUS**

(30) Priority: 15.09.2009 JP 2009213225; 10.08.2010 JP 2010179471
(71) Applicant: Showa Denko K.K., Tokyo 105-8518 (JP)
(72) Inventor: AIHARA Noriyuki, Chichibu-shi Saitama 369-1893 (JP); TAKEUCHI Ryouichi, Chichibu-shi Saitama 369-1893 (JP); MURAKI Noritaka, Chichibu-shi Saitama 369-1893 (JP)
(74) Representative: Strehl Schübel-Hopf & Partner
(86) International application number: PCT/JP2010/065713
(87) International publication number: WO 2011/034018

(57) **Abstract**

Disclosed is a light-emitting diode, which has an infrared emission wavelength of 700nm or more, excellent monochromatism characteristics, and high output and high efficiency and excellent humidity resistance. The light-emitting diode is provided with: a light-emitting section (7), which includes an activity layer, wherein the activity layer emits infrared light and includes a multilayer including a well layer (12) which is made from a composition expressed by the composition formula of (Al_{X}Ga_{1-X}) As (0 ≤X≤1)and a barrier layer (13); a current diffusion layer (8) formed on the light-emitting section (7); and a functional substrate (3) bonded to the current diffusion layer (8).

## Description

### TECHNICAL FIELD

The present invention relates to a light-emitting diode and a light-emitting diode lamp and in particular, to an infrared light emitting diode of high output and light-emitting diode lamp therewith and an illuminating apparatus.
Priority is claimed on Japanese Patent Application No. 2009-213225, filed on September 15, 2009, and Japanese Patent Application No. 2010-179471, filed on August 10, 2010, the contents of both of which are incorporated herein by reference.

### BACKGROUND ART

Infrared light emitting diodes are utilized widely, such as in infrared communication, light sources for various sensors, nightlights etc.
In recent years, plant growth using an artificial light source has been studied. In particular, attention is being paid to a cultivation method using illumination by a light-emitting diode (LED), which has excellent monochromaticity and in which energy saving, long lifetime, and a reduction in size are possible. With respect to photosynthesis, light having a wavelength of around 660 nm to 670 nm is the most preferable light source having high reaction efficiency.

On the other hand, the conventional studies have confirmed that infrared light having a peak wavelength of 730nm is effective as one wavelength which is preferable for shape control of plant upbringing. For example, as a conventional infrared light emitting diode, light emitting layer including AlGaAs obtained by using a liquid phase epitaxial method is put to practical use, and various investigations for realizing high output have been done (for example, Patent Documents 1-3).
An infrared light emitting diode was produced by growing an epitaxial AlGaAs layer thickly on a GaAs substrate by using a liquid phase epitaxial method, wherein the layer is transparent at the emitting wavelength, and removing the GaAs substrate to use the AlGaAs layer as a substrate. Recently, the structure of the infrared light emitting diode (so-called transparent-substrate type) has the highest output.
A peak wavelength range of an infrared light emitting diode is about 700-940nm.

Patent Document 1: Japanese Unexamined Patent Application Publication No. 6-21507
Patent Document 2: Japanese Unexamined Patent Application Publication No. 2001-274454
Patent Document 3: Japanese Unexamined Patent Application Publication No. 7-38148

### DISCLOSURE OF INVENTION

Development of LEDs having further high light-emitting efficiency, as a light source of infrared illumination, is expected in view of performance enhancement, energy saving, and cost. In particular, in order to realize practical use of LED illumination for plant upbringing, which is attracting attention, it is strongly expected that saving electric power, improving humidity resistance, realizing high output. In the case of plant upbringing, humidity resistance is one of the important characteristics because that it is used under high humidity conditions such as spraying or hydroponics.

In view of the circumstances, the object of the present invention is to provide a infrared light emitting diode which has high efficiency and high output, and has superior humidity resistance. In particular, the object of the present invention is to provide the infrared light emitting diode having the wavelength of 730nm, which is preferable for illumination for plant upbringing; and a lamp thereof.

As a result of the inventor's repeated investigation to solve the problem, the inventor found that as a conventional infrared light emitting diode which was used an activity layer of AlGaAs type, there was no type of compound semiconductor layer including the activity layer that could be adhered (bonded) on a transparent substrate; however, when a multiplexing quantum well structure of AlGaAs type was adhered (bonded) on a transparent substrate, higher output than that of the conventional infrared light emitting diode was obtained.
The inventor made further investigation based on this knowledge, and as a result, the present invention as shown in the following was accomplished.

The present invention provides the following embodiments.
(1) A light-emitting diode including: a light-emitting section, which includes an activity layer, wherein the activity layer emits infrared light and includes a multilayer including a well layer which includes a composition expressed by the composition formula of (AlₓGa₁₋ₓ) As (0≤X≤1) and a barrier layer; a current diffusion layer formed on the light-emitting section; and a functional substrate bonded to the current diffusion layer.
(2) The light-emitting diode according to (1), wherein the functional substrate is transparent at an emitting wavelength.
(3) The light-emitting diode according to (1) or (2), wherein the functional substrate includes GaP, sapphire or SiC.
(4) The light-emitting diode according to any one of (1) to (3), wherein the side face of the functional substrate includes
   a perpendicular plane which is close to the light-emitting section, the perpendicular plane is perpendicular to the main light-extraction surface, and
   an inclined plane which is far to the light-emitting section, the inclined plane is inclined inside to the main light-extraction surface.
(5) The light-emitting diode according to (4), wherein the inclined plane includes rough surface.
(6) A light-emitting diode including: a light-emitting section, which includes an activity layer, wherein the activity layer emits infrared light and includes a multilayer including a well layer which includes a composition expressed by the composition formula of (AlₓGa₁₋ₓ) As (0≤X≤1) and a barrier layer; a current diffusion layer formed on the light-emitting section; and a functional substrate which includes a reflection layer having reflection index of 90 % or more at the emitting wavelength, wherein the reflection layer is formed to face the light-emitting section and the functional substrate is bonded to the current diffusion layer.
(7) The light-emitting diode according to (6), wherein the functional substrate includes a silicon or germanium layer.
(8) The light-emitting diode according to (6), wherein the functional substrate includes a metal substrate.
(9) The light-emitting diode according to (8), wherein the metal substrate includes plural metal layers.
(10) The light-emitting diode according to any one of (1) to (9), wherein the current diffusion layer includes GaP.
(11) The light-emitting diode according to any one of (1) to (9), wherein a composition expressed by the composition formula of the current diffusion layer is (AlₓGa₁₋ₓ) As (0≤X≤0.5).
(12) The light-emitting diode according to any one of (1) to (11), wherein a thickness of the current diffusion layer is in the range of 0.5-20µm.
(13) The light-emitting diode according to any one of (1) to (11), wherein a first electrode and a second electrode are installed in the side of the main light extraction surface of the light-emitting diode.
(14) The light-emitting diode according to (13), wherein the first electrode and the second electrode are ohmic electrodes.
(15) The light-emitting diode according to (13) or (14), wherein a third electrode is further installed in the back side of the main light extraction surface of the light-emitting diode.
(16) A light-emitting diode lamp including the light-emitting diode according to any one of (1) to (15).
(17) A light-emitting diode lamp including the light-emitting diode according to (15), wherein the first electrode or the second electrode is connected to the third electrode at an approximate electric potential.
(18) An illuminating apparatus including plural light-emitting diodes according to any one of (1) to (15).

In the present invention, the "functional substrate" is a substrate which is bonded to the compound semiconductor layer through the current diffusion layer and supports the compound semiconductor layer, wherein the compound semiconductor layer is obtained by forming the compound semiconductor layer on a growth substrate and then removing the growth substrate. When a predetermined layer is formed on the current diffusion layer and a support substrate is bonded to the compound semiconductor layer on the predetermined layer, the "functional substrate" is a substrate including the predetermined layer and the support substrate.

Since the light-emitting diode of the invention includes: a light-emitting section, which includes an activity layer, wherein the activity layer emits infrared light and includes a multilayer including a well layer which includes a composition expressed by the composition formula of (AlₓGa₁₋ₓ) As (0≤X≤1) and a barrier layer; a current diffusion layer formed on the light-emitting section; and a functional substrate bonded to the current diffusion layer, the invention shows a high output in comparison with a conventional infrared light emitting diode. Particularly, since the functional substrate is transparent at the emitting wavelength, high output and high efficiency are observed without absorbing the emitting light by the light-emitting section. In addition, since the activity layer includes a multiplexing well structure having well layers including composition formula (AlₓGa₁₋ₓ) As (0 ≤X ≤ 1) and barrier layers, the diode have a superior monochromatism. In addition, since the activity layer includes the multilayer having the well layer including composition formula (AlₓGa₁₋ₓ) (0 ≤X ≤ 1) and the barrier layer, it is preferable to be mass-produced by using a MOCVD method.

Since the functional substrate is made from GaP, sapphire, SiC, silicone or germanium, the material of the functional substrate is hard to be corroded. As a result, humidity resistance is improved.
In addition, as the most preferable combination of light-emitting diode of the present invention, both the functional substrate and the current diffusion layer are made from GaP. Therefore, bonding becomes easier and the bond strength becomes stronger. In addition, since the same materials are used, the light loss in the interface is very small. Therefore, it is the most preferable to obtain high output.

Since the light-emitting diode lamp of the present invention has an emitting infrared light wavelength of 730nm, excellent monochromatism, high output and high efficiency, as well as excellent moisture resistance, for example, it is preferable to be used as an illumination source of plant upbringing under a high humidity atmosphere.

### BRIEF DESCRIPTION OF DRAWINGS

FIG. 1 is a plan view of a light-emitting diode lamp using a light-emitting diode related to an embodiment of the invention.
FIG. 2 is a cross-sectional schematic view taken along line A-A' in FIG. 1 of the light-emitting diode lamp using the light-emitting diode related to the embodiment of the invention.
FIG. 3 is a plan view of the light-emitting diode related to the embodiment of the invention.
FIG. 4 is a cross-sectional schematic view taken along line B-B' in FIG. 3 of the light-emitting diode related to the embodiment of the invention.
FIG. 5 is an enlarged cross-sectional view for describing the configuration of an electrode protection film of the light-emitting diode related to the embodiment of the invention.
FIG. 6 is a cross-sectional schematic view of an epitaxial wafer which is used in the light-emitting diode related to the embodiment of the invention.
FIG. 7 is a cross-sectional schematic view of a bonded wafer which is used in the light-emitting diode related to the embodiment of the invention.
FIG. 8 A is a plan view of a light-emitting diode lamp using a light-emitting diode related to another embodiment of the invention, and 8B is a cross-sectional schematic view taken along line C-C' in FIG. 8 A.
FIG. 9 is a cross-sectional schematic view of a light-emitting diode lamp using a light-emitting diode related to another embodiment of the invention.

### DETAIL DESCRIPTION OF THE INVENTION

Hereinafter, a light-emitting diode related to an embodiment to which the invention is applied, as well as a light-emitting diode lamp using the light-emitting diode, will be described in detail by using the drawings. In addition, in the drawings used in the following description, there is a case where characteristic sections are enlarged and shown for convenience in order to facilitate the understanding of features, and the size ratio or the like of each constituent element is not necessarily the same as the actual condition.

### Light-Emitting Diode Lamp

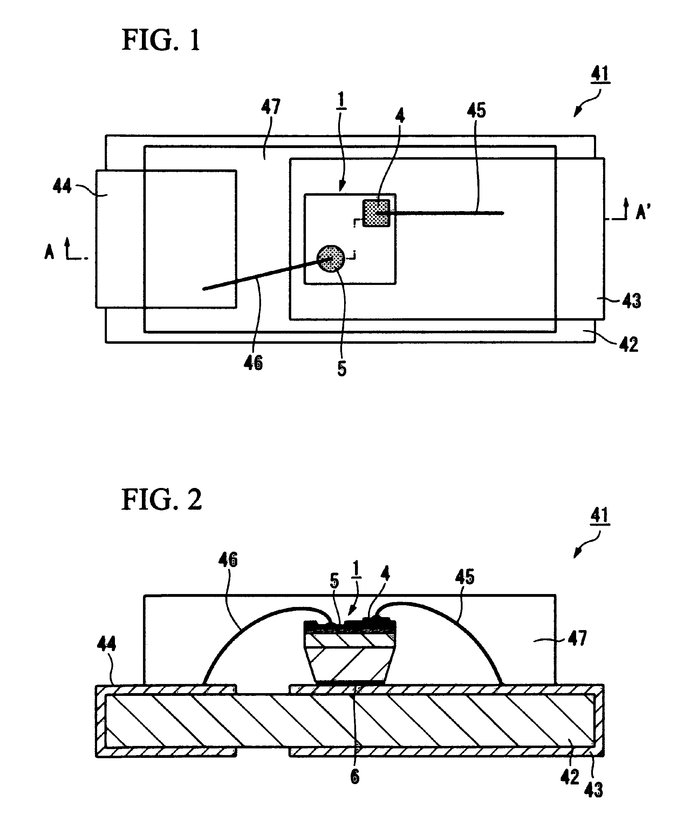

FIGS. 1 and 2 are diagrams for describing a light-emitting diode lamp using a light-emitting diode related to an embodiment to which the invention is applied, wherein FIG. 1 is a plan view and FIG. 2 is a cross-sectional view along line A-A' shown in FIG. 1.

As shown in FIGS. 1 and 2, in a light-emitting diode lamp 41 using a light-emitting diode 1 of this embodiment, one or more of the light-emitting diodes 1 are mounted on the surface of a mount substrate 42. More specifically, on the surface of the mount substrate 42, an n-electrode terminal 43 and a p-electrode terminal 44 are provided. Further, an n-type ohmic electrode 4 that is a first electrode of the light-emitting diode 1 and the n-electrode terminal 43 of the mount substrate 42 are connected to each other by using a gold wire 45 (wire bonding). On the other hand, a p-type ohmic electrode 5 that is a second electrode of the light-emitting diode 1 and the p-electrode terminal 44 of the mount substrate 42 are connected to each other by using a gold wire 46. Further, as shown in FIG. 2, on the surface on the opposite side to the surface on which the n-type and p-type ohmic electrodes 4 and 5 of the light-emitting diode 1 are provided, a third electrode 6 is provided, and the light-emitting diode 1 is connected onto the n-electrode terminal 43 by the third electrode 6, thereby being fixed to the mount substrate 42. Here, n type ohmic electrode 4 and the third electrode 6 are connected each other by n-electrode terminal 43 in the same electric potential or approximate electric potential. By using the third electrode, damage of the activity layer can be prevented by introducing the current between the third electrode and p-electrode without excess current drifting in activity layer when excess reverse voltage is applied. Since a reflection structure is added between the third electrode and substrate interface side, high output is possible. In addition, a simple and easy assembly technique such as eutectic die bond is available to be used by adding eutectic metal or tin solder to the surface of the third electrode. The surface of the mount substrate 42, on which the light-emitting diode 1 is mounted, is sealed by a general sealing resin 47, such as silicon or epoxy resin.

Light-Emitting Diode (The First Embodiment)

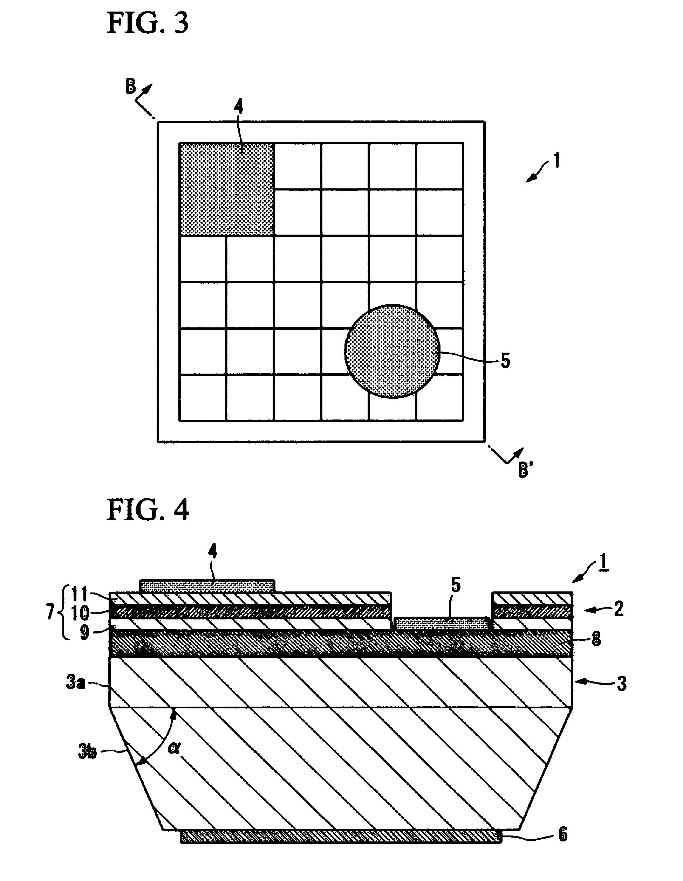

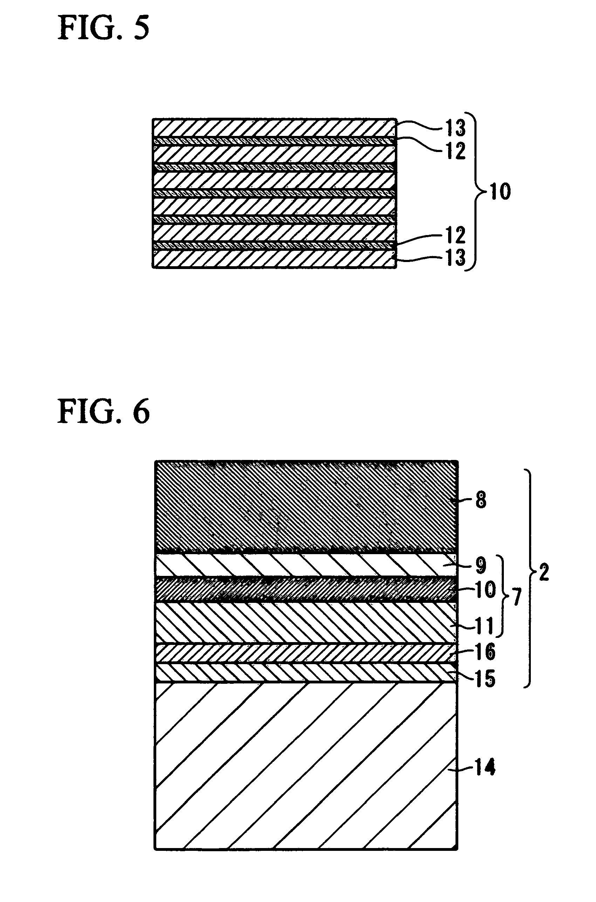

FIGS. 3 and 4 are diagrams for describing the light-emitting diode related to the first embodiment to which the invention is applied, wherein FIG. 3 is a plan view and FIG. 4 is a cross-sectional view along line B-B' shown in FIG. 3. In addition, FIG. 5 is cross section of a multilayer.
The light-emitting diode of the first embodiment includes: a light-emitting section 7, which includes an activity layer 10, wherein the activity layer 10 emits infrared light and includes a multilayer including a well layer 12 which includes a composition expressed by the composition formula of (AlₓGa₁₋ₓ) As (0≤X≤1) and a barrier layer 13; a current diffusion layer 8 formed on the light-emitting section; and a functional substrate bonded to the current diffusion layer 8.
The main light extraction surface in the present embodiment is the surface that is the opposite side of the bonding surface of the compound semiconductor layer with the functional substrate 3.

The compound semiconductor layer (also called an epitaxial growth layer) 2 has a structure in which a pn-junction type light-emitting section 7, and a current diffusion layer 8 are sequentially stacked, as shown in FIG. 4. A known functional layer can be added to the structure of the compound semiconductor layer 2 on a timely basis. For example, it is possible to provide a known layer structure such as a contact layer for reducing contact resistance of the ohmic electrodes, current diffusion layer to make general of light-emitting section scatter element driving current planarly, or a current blocking layer or current constriction layer for restricting an area through which an element driving current flows. In addition, it is preferable that the compound semiconductor layer 2 be a layer formed by epitaxial growth on a GaAs substrate.

The light-emitting section 7 has a configuration in which at least a p-type lower clad layer 9, lower guide layer (not shown), a light-emitting layer(activity layer) 10, upper part guide layer (not shown) and an n-type upper clad layer 11 are sequentially laminated on the current diffusion layer 8, as shown in FIG. 4. That is, in order to obtain high-intensity luminescence, it is preferable that the light-emitting section 7 be made to be a so-called double hetero (DH) structure which includes the lower clad layer 9 and the upper clad layer 11 disposed to confront each other on the lower side and the upper side of the light-emitting layer 10 in order to "confine" a carrier leading to radiation recombination, and luminescence in the light-emitting layer 10.

It is preferable for the activity layer 10 to include a well structure to control emitting light wavelength of light-emitting diode (LED) as shown in FIG 5. In other words activity layer 10 includes a multi-layer structure (multilayer) having well layers and barrier layers, and has barrier layers 13 at both ends of the multi-layer structure.

It is preferable that the layer thickness of the light-emitting layer 10 be in a range of 0.02 µm to 2 µm. Further, a conduction type of the light-emitting layer 10 is not particularly limited and any of an un-doped type, a p type, and an n type can be selected. In order to increase light-emitting efficiency, it is preferable to make the light-emitting layer 10 be the un-doped type having excellent crystallinity or have a carrier concentration of less than 3x10¹⁷ cm⁻³.

It is preferable for well layer 12 to have composition formula of (AlₓGa₁₋ₓ) As (0 ≤X≤0.35). X can be adjusted to obtain the most preferable emitting light wavelength.

As the thickness of well layer 12, a range of 3-20 nm is preferred. More preferably, there is in the range of 5-10 nm.

Barrier layer 13 has composition formula of (AlₓGa₁₋ₓ)As (0 ≤X≤1). As X, 0.3-0.7 ranges are preferable, and 0.4-0.6 ranges are more preferable.
It is preferable for thickness of barrier layer 13 to be thicker than thickness of well layer 12. As a result, light-emitting efficiency of well layer 12 can be improved.

In the multi-layer structure having well layers 12 and barrier layers 13, the pair number of alternately laminating a well layer 12 and barrier layer 13 is not limited particularly, but it is preferable to be 40 pairs or less and two pairs or more. In other words, it is preferable that activity layer 10 includes 2-40 layers of the well layer 12. Since the activity layer has a preferred light-emitting efficiency, it is preferable that there are more than two layers of well layers 12. On the other hand, since carrier density in the well layer 12 and barrier layer 13 is low, when too many pairs are used, forward direction voltage (V_{F}) increases. Because of this, it is preferable to use 40 pairs or less and more preferable to use 30 pairs or less.

The lower clad layer 9 and the upper clad layer 11 are respectively provided on the lower surface and the upper surface of the light-emitting layer 10, as shown in FIG. 4. Specifically, the lower clad layer 9 is provided on the lower surface of the light-emitting layer 10 and the upper clad layer 11 is provided on the upper surface of the light-emitting layer 10.

As the material of lower clad layer 9 and upper clad layer 11, a material having a larger band gap than well layer 12 is preferable, and a material having a larger band gap than the barrier layer 13 is more preferable. As the material, the composition having (AlₓGa₁₋ₓ) in which X is in the range of 0.3-0.8 is preferable.

The lower clad layer 9 and the upper clad layer 11 are constituted such that polarities are different from each other. Further, with respect to the carrier concentration and the thicknesses of the lower clad layer 9 and the upper clad layer 11, known preferred ranges can be used, and it is preferable to optimize conditions such that the light-emitting efficiency of the light-emitting layer 10 is increased. In addition, by control of lower clad layer 9 and composition of upper clad layer 11, it can make reduce buckling of compound semiconductor layer 2.

Specifically, as the lower clad layer 9, it is preferable to use a semiconductor material made of, for example, Mg or Zn-doped p-type (AlₓGa₁₋ₓ)As (0.3≤X≤1). Further, with respect to the carrier concentration, a range of 2x10¹⁷ to 2x10¹⁸ cm⁻³ is preferable, and with respect to the layer thickness, a range of 0.5 µm to 5 µm is preferable.

On the other hand, as the upper clad layer 11, it is preferable to use a semiconductor material made of, for example, Si or Te-doped n-type (AlₓGa₁₋ₓ)As (0.3≤X≤1)).Further, with respect to the carrier concentration, a range of 1x10¹⁷cm⁻³ to 1x10¹⁸ cm⁻³is preferable, and with respect to the layer thickness, a range of 0.5 µm to 5 µm is preferable. In addition, the polarities of the lower clad layer 9 and the upper clad layer 11 can be appropriately selected in consideration of an element structure of the compound semiconductor layer 2.

Further, intermediate layers for slowly changing band discontinuity between both layers may also be provided between the lower clad layer 9 and the light-emitting layer 10, between the light-emitting layer 10 and the upper clad layer 11, and between the upper clad layer 11 and the current diffusion layer 8. In this case, it is preferable that each intermediate layer be composed of a semiconductor material having a forbidden band width intermediate to that of between both the layers.

Further, a known layer structure such as a contact layer for reducing contact resistance of the ohmic electrodes, or a current blocking layer, current diffusion layer to make general of light-emitting section scatter element driving current planarly, or current constriction layer for restricting an area through which an element driving current flows, can be provided above the constitution layer of the light-emitting section 7.

As the current diffusion layer 8, GaP or a material having a composition of (AlₓGa₁₋ₓ)As (0≤X≤0.5)) can be applied. Although the above X also depends on an element structure of the compound semiconductor layer 2, since a material having a low Al concentration is chemically stable, it is preferable that the above X be 0.4 or less, and it is more preferable that it be 0.3 or less. When GaP is used as the current diffusion layer 8, and functional substrate 3 GaP substrate is used, it is easy to bond them and high bond strength can be obtained.
In addition, it is preferable that the thickness of current diffusion layer 8 is in the range of 0.5-20 µm. When less that 0.5µm, current diffusion is insufficient. When more than 20 µm, the production cost increases since it is necessary to form crystal to such thickness.

The functional substrate 3 is bonded to the surface on the opposite side to the main light extraction surface of the compound semiconductor layer 2. That is, the functional substrate 3 is bonded to the current diffusion layer 8 side constituting the compound semiconductor layer 2, as shown in FIG. 4. The functional substrate 3 is made of a material which has sufficient strength to mechanically support the light-emitting section 7 and is capable of transmitting light which is emitted from the light-emitting section 7 and which is optically transparent to the luminescence wavelength from the light-emitting layer 10. In addition, the construction material that is chemically stable and that was superior in humidity resistance is preferable. For example, it is the construction material that does not contain the Al which is easy to corrode.
As the functional substrate 3, it is preferable that the substrate is superior in humidity resistance, and it is more preferable that the substrate is GaP or SiC having a good heat-conduction. In addition, it is preferable that the substrate is sapphire having a strong mechanical strength. Particularly, GaP is the most preferable substrate material because that the thermal expansion coefficient is near to AlGaAs.
In addition, it is preferable that the functional substrate 3 be made to have a thickness of, for example, about 50 µm or more in order to support the light-emitting section 7 with a mechanically sufficient strength. Further, in order to facilitate mechanical working of the compound semiconductor layer 2 after the functional substrate 3 is bonded to the compound semiconductor layer 2, it is preferable to set the thickness of the functional substrate 3 not to exceed 300 µm. That is, it is most preferable that the functional substrate 3 be constituted by an GaP substrate having a thickness of not less than about 50 µm and not more than about 300 µm.

In addition, as shown in FIG. 4, the side face of the functional substrate 3 includes a perpendicular plane 3a which is close to the compound semiconductor 2, wherein the perpendicular plane is perpendicular to the main light-extraction surface; and an inclined plane 3b which is far to the compound semiconductor 2, wherein the inclined plane is inclined inside to the main light-extraction surface. As a result, the light emitted from the activity layer light 10 to the side of the functional substrate 3 can be extracted outside efficiently. In addition, among the light emitted from the activity layer light 10 to the side of the functional substrate 3, the light, which is reflected back in perpendicular plane 3a, can be extracted from the inclined plane 3b, and the light, which is reflected back in inclined plane 3b, can be extracted from the perpendicular plane 3a. As a result, extraction efficiency of light can be raised because of a synergistic effect of perpendicular plane 3a and inclined plane 3b.

In addition, in the present embodiment, it is preferable that angle α between the inclined plane 3b and the plane parallel to light-emitting surface is in the range of 55 to 80 degrees. In such range, the light reflected back by the functional substrate 3 can be extracted efficiently outside.
In addition, it is preferable that the thickness of (thickness direction) of perpendicular plane 3a is in a range of 30 to 200 µm.When the thickness of (thickness direction) of perpendicular plane 3a is in a range of 30 to 200 µm. the light reflected back by the functional substrate 3 can be returned to light-emitting surface efficiently, and further be extracted from the main light-extraction surface. As a result, the light-emitting efficiency of light-emitting diode 1 can be improved.

In addition, it is preferable for the inclined plane 3b of the functional substrate 3 to be rough-processed. Since the inclined plane 3b is rough-processed, the light extraction efficiency can be raised. In other words, a total reflection by the inclined plane 3b is restrained by making inclined plane 3b rough, and light extraction efficiency can be improved.

There may be a high resistive layer in the bonding interface between the compound semiconductor layer 2 and the functional substrate 3. In other words, a high resistive layer (not shown in drawings) may be installed between compound semiconductor layer 2 and functional substrate 3. When the high resistive layer has a higher resistance value than the functional substrate 3 and the high resistive layer is installed, it has function to reduce current of an opposite direction from the current diffusion layer 8 of the compound semiconductor layer 2 to the functional substrate 3. In addition, the bonding structure shows a voltage resistance to the voltage of the opposite direction that is applied from the functional substrate 3 to the current diffusion layer 8 carelessly. However, the breakdown voltage is preferably set to a lower value than the voltage of opposite direction of light-emitting section 7 of a pn junction type.
In addition, the current paths can be installed by the connection with the third electrode 6 in backside of the chip, or with an Ag paste.

The n-type ohmic electrode 4 and the p-type ohmic electrode 5 are low-resistance ohmic contact electrodes provided on the main light extraction surface of the light-emitting diode 1. Here, the n-type ohmic electrode 4 is provided above the upper clad layer 11 and, for example, AuGe, or an alloy composed of Ni allow/Au can be used. On the other hand, the p-type ohmic electrode 5 is provided on the exposed upper surface 8a of the current diffusion layer 8, as shown in FIG. 4, and an alloy composed of AuBe/Au or AuZn/Au can be used.

Here, in the light-emitting diode 1 of this embodiment, it is preferable to form the p-type ohmic electrode 5 as the second electrode on the current diffusion layer 8. By such a configuration, the effect of lowering the operating voltage can be obtained. Further, by forming the p-type ohmic electrode 5 on the current diffusion layer 8 made of p-type GaP, excellent ohmic contact can be obtained, so that it is possible to lower the operating voltage.

In addition, in this embodiment, it is preferable that the polarity of the first electrode is n type, and the polarity of the second electrode is p type. High brightness of light-emitting diode 1 can be achieved when such a constitution is used. On the other hand, when the first electrode is p type, current diffusion becomes worse, and brightness become lower. In contrast, current diffusion is improved when the first electrode is n type, and high brightness of light-emitting diode 1 can be achieved.

In the light-emitting diode 1 of this embodiment, it is preferable to dispose the n-type ohmic electrode 4 and the p-type ohmic electrode 5 so as to be at diagonal positions, as shown in FIG. 3. Further, it is most preferable to take a configuration in which the p-type ohmic electrode 5 is surrounded by the compound semiconductor layer 2. By such a configuration, the effect of lowering the operating voltage can be obtained. Further, the p-type ohmic electrode 5 is surrounded on all four sides by the n-type ohmic electrodes 4, whereby it becomes easy for an electric current to flow in all directions, and as a result, the operating voltage is lowered.

Further, in the light-emitting diode 1 of this embodiment, it is preferable to form the n-type ohmic electrode 4 into the form of a reticulation such as a honeycomb or a grating shape, as shown in FIG. 3. By such a configuration, the effect of reducing V_{F} or the effect of improving reliability can be obtained. Further, by forming it into the form of a grid, it is possible to uniformly inject an electric current into the light-emitting layer 10, and as a result, the effect of improving reliability can be obtained. In addition, in the light-emitting diode 1 of this embodiment, it is preferable to constitute the n-type ohmic electrode 4 by a pad-shaped electrode (a pad electrode) and an electrode of a linear shape (a linear electrode) having a width of 10 µm or less. By such a configuration, higher brightness can be attained. Further, by narrowing the width of the linear electrode, it is possible to increase an opening area of the main light extraction surface, so that it is possible to achieve higher brightness.

### Method of Manufacturing Light-Emitting Diode

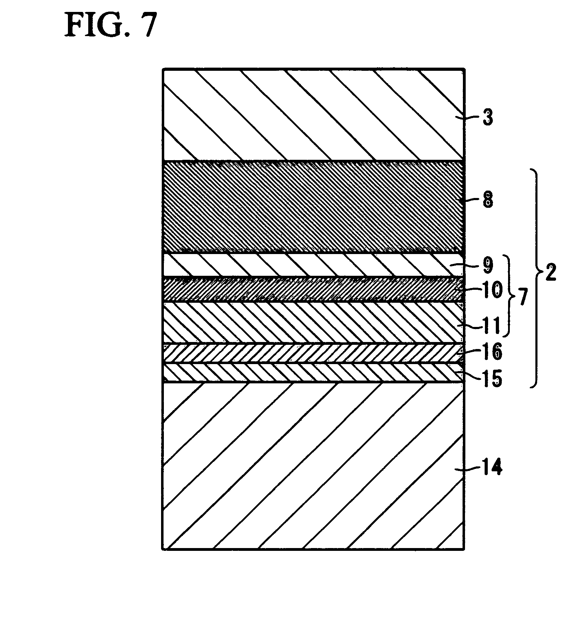

Next, a method of manufacturing the light-emitting diode 1 of this embodiment will be described. FIG. 6 is a cross-sectional view of an epitaxial wafer which is used in the light-emitting diode 1 of this embodiment. Further, FIG. 7 is a cross-sectional schematic view of a bonded wafer which is used in the light-emitting diode 1 of this embodiment.

### Process of Forming Compound Semiconductor Layer

First, as shown in FIG. 6, the compound semiconductor layer 2 is made. The compound semiconductor layer 2 is made by sequentially laminating a buffer layer 15 made of GaAs, an etching stopper layer (not shown) provided in order to be used for selective etching, a contact layer 16 made of Si-doped n-type GaInP, the n-type upper clad layer 11, the light-emitting layer 10, the p-type lower clad layer 9, and the current diffusion layer 8 made of Mg-doped p-type GaP, on a GaAs substrate 14.

As the GaAs substrate 14, a commercially available single-crystal substrate manufactured by a known manufacturing method can be used. It is preferable that the epitaxially grown surface of the GaAs substrate 14 be smooth. With respect to the plane orientation of the surface of the GaAs substrate 14, a substrate in which epitaxial growth is easy and which is mass-produced and has a (100) plane and a plane deviated within ±20° from (100) is preferable in terms of stability of quality. Further, it is more preferable that a range of the plane orientation of the GaAs substrate 14 be 15°±5° deviated in a (0-1-1) direction from a (100) direction.

It is preferable that the dislocation density of the GaAs substrate 14 be low in order to improve the crystallinity of the compound semiconductor layer 2. Specifically, for example, 10000 pieces cm⁻² or less, preferably, 1000 pieces cm⁻² or less is preferable.

The GaAs substrate 14 may also be any of an n-type and a p-type. The carrier concentration of the GaAs substrate 14 can be appropriately selected in terms of a desired electric conductivity and an element structure. For example, in a case where the GaAs substrate 14 is a silicon-doped p-type, it is preferable that the carrier concentration be in a range of 1x10¹⁷ cm⁻³ to 5x10¹⁸ cm⁻³. In contrast, in a case where the GaAs substrate 14 is a zinc-doped p-type, it is preferable that the carrier concentration be in a range of 2x10¹⁸ cm⁻³ to 5x10¹⁹cm⁻³.

The thickness of GaAs substrate 14 may be in an appropriate range according to size of substrate. It may be broken during a manufacturing process of compound semiconductor layer 2, if the thickness of GaAs substrate 14 is thinner than that in an appropriate range. On the other hand, material costs rise if thickness of GaAs substrate 14 is thicker that that in the appropriate range. Therefore, when substrate size of GaAs substrate 14 is large, for example, in the case of the diameter of 75 mm, a thickness of 250-500µm is preferable to preclude crack in handling. In the case of a diameter of 50mm, a thickness of 200-400µm is preferable, and thickness of 350-600µm is preferable in the case of a diameter of 100 mm.

Since the thickness of substrate is increased depending on substrate size of GaAs substrate 14, warping of compound semiconductor layer 2 due to light-emitting section 7 can be reduced. As a result, distribution of temperature in epitaxial growth becomes homogeneous, and then in-plane wavelength distribution of the activity layer 10 can be lowered. In addition, the shape of the GaAs substrate 14 may be a rectangle, without limitation to circle in particular.

The buffer layer 15 is provided in order to reduce lattice mismatch between the GaAs substrate 14 and the constitution layer of the light-emitting section 7. Therefore, if the quality of a substrate or an epitaxial growth condition is selected, the buffer layer 15 is not necessarily required. Further, it is preferable that a material of the buffer layer 15 be the same material as that of the substrate which is subjected to epitaxial growth. Therefore, in this embodiment, as the buffer layer 15, it is preferable to use GaAs like the GaAs substrate 14. Further, as the buffer layer 15, in order to reduce the propagation of a defect, a multilayer film made of a material different from the GaAs substrate 14 can also be used. It is preferable that the thickness of the buffer layer 15 be 0.1 µm or more and it is more preferable that it be 0.2 µm or more.

The contact layer 16 is provided in order to lower contact resistance with an electrode. It is preferable that a material of the contact layer 16 be a material which has a larger bond gap than that of the activity layer 10, and AlₓGa₁₋ₓ As, (AlₓGa₁₋ₓ)_{y}ln_{1-y}P (0≤X≤1, 0<Y≤1) is preferable. Further, it is preferable that the lower limit of the carrier concentration of the contact layer 16 be 5x10¹⁷ cm⁻³ or more in order to lower contact resistance with an electrode, and 1x10¹⁸ cm⁻³ or more is more preferable. It is preferable that the upper limit of the carrier concentration be 2x10¹⁹ cm⁻³ or less where the lowering of crystallinity easily occurs. With respect to the thickness of the contact layer 16, 0.5 µm or more is preferable and 1 µm or more is preferred. The upper limitation of the thickness is not limited particularly, and 5 µm or less is preferable when cost of epitaxial growing process is taken into consideration.

In this embodiment, it is possible to apply a known growth method such as a molecular beam epitaxial method (MBE) or a low-pressure metal-organic chemical vapor deposition method (an MOCVD method). In particular, it is preferable to apply the MOCVD method having excellent mass-productivity. Specifically, in the GaAs substrate 14 which is used for the epitaxial growth of the compound semiconductor layer 2, it is preferable to remove contamination of the surface or a natural oxide film by carrying out a pretreatment such as a cleaning process or a thermal treatment before the growth. Each layer which is included in the above compounds semiconductor layer 2 is formed by setting the GaAs substrate 14 of a diameter of 50-150 mm in MOCVD apparatus, and then making them grow up epitaxially. In addition, as a MOCVD apparatus, commercial large-scale apparatus such as a planetary or a high-speed rotary type can be used.

When each layer of the compound semiconductor layer 2 is epitaxially grown, as a raw material of a group III constituent element, for example, trimethylaluminum ((CH₃)₃Al), trimethylgallium ((CH₃)₃Ga), and trimethylindium ((CH₃)₃In) can be used. Further, as a doping material of Mg, for example, bis-cyclopentadienyl magnesium (bis-(C₅H₅)₂Mg) or the like can be used. Further, as a doping material of Si, for example, disilane (Si₂H₆) or the like can be used. Further, as a raw material of a group V constituent element, phosphine (PH₃), arsine (AsH₃), or the like can be used. Further, as the growth temperature of each layer, in the case of using p-type GaP as the current diffusion layer 8, a temperature in a range of 720 °C to 770 °C can be applied, and in each of the other layers, a temperature in a range of 600 °C to 700 °C can be applied. Further, the carrier concentration and the layer thickness of each layer and a temperature condition can be appropriately selected.

In the compound semiconductor layer 2 made in this way, an excellent surface state in which crystal defects are few can be obtained. Further, the compound semiconductor layer 2 may also be subjected to a surface treatment such as polishing considering an element structure.

### Process of Bonding Functional Substrate

Next, the compound semiconductor layer 2 and the functional substrate 3 are bonded to each other. In the bonding of the compound semiconductor layer 2 and the functional substrate 3, first, mirror finishing is carried out by polishing the surface of the current diffusion layer 8 constituting the compound semiconductor layer 2. Next, the functional substrate 3 which is attached to the mirror-polished surface of the current diffusion layer 8 is prepared. In addition, the surface of the functional substrate 3 is polished into a mirror surface before it is bonded to the current diffusion layer 8. Next, the compound semiconductor layer 2 and the functional substrate 3 are loaded into a general semiconductor material attachment apparatus, and the mirror-polished surfaces of the two are irradiated with an Ar beam neutralized by collision of electrons in a vacuum. Thereafter, bonding can be performed at room temperature by overlapping the surfaces of the two over each other and then applying a load thereto in the attachment apparatus in which the vacuum is maintained (refer to FIG. 7). As the bonding, it is preferable that the materials of the bonding interface is the same material from the view point of a stable bonding condition
Normal temperature bonding under such a vacuum is the most preferable for bonding (pasting), however, eutectic metal or adhesion may be used.

### Process of Forming the First and the Second Electrodes

Next, the n-type ohmic electrode 4 of the first electrode and the p-type ohmic electrode 5 of the second electrode are formed. In the formation of the n-type ohmic electrode 4 and the p-type ohmic electrode 5, first, the GaAs substrate 14 and the GaAs buffer layer 15 are selectively removed from the compound semiconductor layer 2 bonded to the functional substrate 3, by an ammonia-based etchant. Next, the n-type ohmic electrode 4 is formed on the exposed surface of the contact layer 16. Specifically, after AuGe and Ni alloy/Au are laminated so as to become an arbitrary thickness by a vacuum deposition method, the shape of the n-type ohmic electrode 4 is formed by performing patterning with the use of, for example, general photolithographic methods.

Next, the current diffusion layer 8 is exposed by selectively removing the contact layer 16, the upper clad layer 11, the light-emitting layer 10, and the lower clad layer 9, and the p-type ohmic electrode 5 is then formed on the exposed surface (the upper surface 8a). Specifically, after Au/Be/Au are laminated so as to become an arbitrary thickness by a vacuum deposition method, the shape of the p-type ohmic electrode 5 is formed by performing patterning with the use of, for example, general photolithographic means. Thereafter, by performing alloying by performing a thermal treatment in conditions of, for example, 400 °C to 500 °C and 5 minutes to 20 minutes, it is possible to form the low-resistance n-type and p-type ohmic electrodes 4 and 5.

### Processing Functional Substrate

Next, the shape of functional substrate 3 is processed. The functional substrate 3 is processed by firstly performing a V-shaped groove on the surface on which the third electrode 6 is not formed. And an inclined plane 3b is formed, which has an angle α between the inside surface of V-shaped groove in the side of the third electrode 6 and the plane parallel to light-emitting surface. Secondly, Dice cutting is performed in predetermined distance from the side of compound semiconductor layer 2, and chips are formed. In addition, the perpendicular plane 3a of the functional substrate 3 is formed by dice cutting during the formation of chips.

As a method of forming the inclined plane 3b, it is not limited in particular, a method of combination of conventional methods such as wet etching, dry etching, scribing method, laser machining, can be used. However, it is the most preferable to use a dice cutting method having high controllability of shape and high productivity. Manufacture yield can be improved by using the dice cutting method.

As a method of forming the perpendicular plane 3a, it is not limited in particular, however, it is preferable that a scribe-breaking method, a laser machining method or a dice cutting method be used. However, when a laser machining method or a dice cutting method is used, manufacture cost can be lowered. In other words, manufacture cost can be lowered in mass-producing light-emitting diodes because that there is no necessity for designing cutting margin in the case of chip isolation. On the other hand, the dice cutting method is superior in cutting stability.

Finally, a crush layer and fouling are etched with a mixed solution of sulfuric acid and hydrogen peroxide if necessary. In this way the light-emitting diode 1 is produced.

### Method of Manufacturing Light-Emitting Diode Lamp

Next, a method of manufacturing the light-emitting diode lamp 41 using the light-emitting diode 1, that is, a method of mounting the light-emitting diode 1 will be described.
As shown in FIGS. 1 and 2, a given quantity of light-emitting diodes 1 are mounted on the surface of the mount substrate 42. In the mounting of the light-emitting diode 1, first, alignment of the mount substrate 42 and the light-emitting diode 1 is performed, thereby disposing the light-emitting diode 1 at a given position on the surface of the mount substrate 42. Next, the light-emitting diode 1 is die-bonded to the surface of the mount substrate 42 by Ag paste. Next, the n-type ohmic electrode 4 of the light-emitting diode 1 and the n-electrode terminal 43 of the mount substrate 42 are connected to each other by using the gold wire 45 (wire bonding). Next, the p-type ohmic electrode 5 of the light-emitting diode 1 and the p-electrode terminal 44 of the mount substrate 42 are connected to each other by using the gold wire 46. Finally, the surface of the mount substrate 42 on which the light-emitting diode 1 is mounted is sealed by a general epoxy resin 47. In this way, the light-emitting diode lamp 41 using the light-emitting diode 1 is manufactured.

In addition, emission spectrum of light-emitting diode lamp 41, for example, having a peak light wavelength in a range of 720-760 nm, can be obtained by adjusting the composition of the activity layer 10. In addition, since dispersion of well layer 12 and barrier layer 13 in activity layer 10 are depressed by current diffusion layer 8a, half-band width of emission spectrum becomes falling in the range of 10-40 nm.

As discussed above, according to the present embodiment, light-emitting diode 1 includes a compound semiconductor layer 2 including light-emitting section 7 having well layer 12 made from composition formula (AlₓGa₁₋ₓ)As (0 ≤X ≤ 0.35).

In addition, on the light-emitting section 7, a current diffusion layer 8 is installed in the light-emitting diode 1 of the present embodiment. Since the current diffusion layer 8 is transparent for the emitting light wavelength, it does not absorb the emission of light from light-emitting section 7. As a result, the light-emitting diode 1 having high output and high efficiency can be obtained. The functional substrate, as a stable material, has superior humidity resistance without worrying about corrosion.

Thus, according to light-emitting diode 1 of the present embodiment, the light-emitting diode 1 having an emitting light wavelength of infrared light, superior monochromatism, high output and high efficiency, and humidity resistance can be provided. In addition, according to the light-emitting diode 1 of the present embodiment, the light-emitting diode 1 having high output with efficiency more than about 1.5 times than the light-emitting diode of transparent substrate AlGaAs type, which was produced by conventional liquid phase epitaxial method, can be provided. In addition, reliability under high temperature and high humidity is improved, too.

In addition, according to the present embodiment, the light-emitting diode lamp 41 includes light-emitting diode 1 having the emitting light wavelength of about 730 nm, superior monochromatism, high output and high efficiency, and humidity resistance. Therefore, the light-emitting diode lamp 41 which is preferable for illumination for plant upbringing can be provided.

### Light-emitting Diode (Second Embodiment)

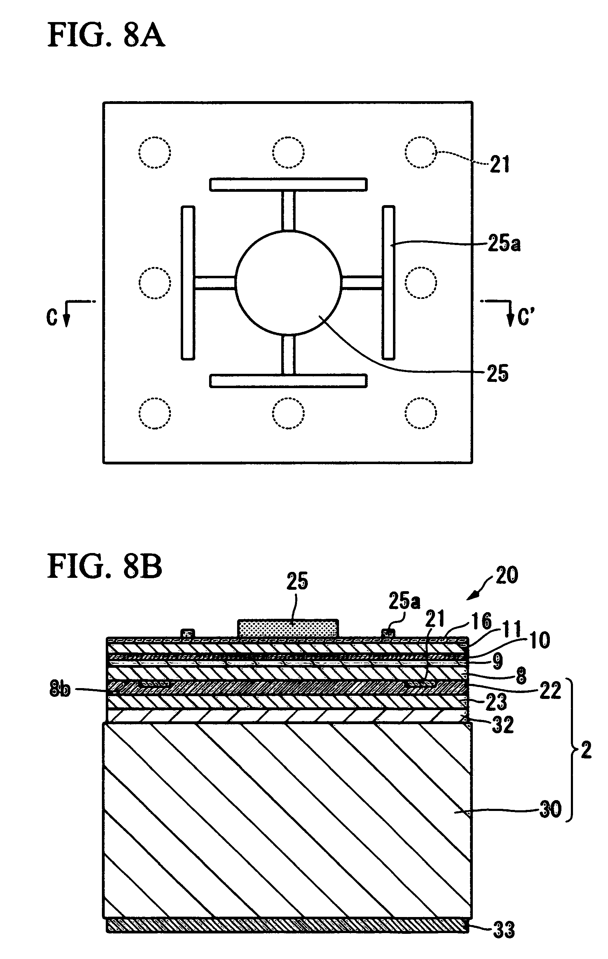

FIGS. 8 A and 8B are diagrams for describing the light-emitting diode related to the second embodiment to which the invention is applied, wherein FIG. 8 A is a plan view and FIG. 8B is a cross-sectional view along line C-C' shown in FIG. 8 A.
The light-emitting diode 20 of the second embodiment includes: a light-emitting section, which includes an activity layer 10, wherein the activity layer 10 emits infrared light and includes a multilayer including a well layer which includes a composition expressed by the composition formula of (AlₓGa₁₋ₓ) As (0 ≤X≤1) and a barrier layer; a current diffusion layer 8; and a functional substrate 31 which includes a reflection layer 23 having reflection index of 90 % or more at the emitting wavelength, wherein the reflection layer 23 is formed to face the light-emitting section and the functional substrate 31 is bonded to the current diffusion layer 8.

Since the light-emitting diode of the second embodiment includes the functional substrate 31 having the reflection layer 23 having reflection index of 90 % or more at the emitting wavelength, emitting light can be extracted from the main light extraction surface effectively.
As example shown in FIGs. 8A and 8B, the functional substrate 31 includes a reflection structure including a second electrode 21 on lower surface 8b of the current diffusion layer 8, a transparent conducting layer 22 and a reflection layer 23 which are laminated to cover the second electrode 21; and a layer (substrate) 30 including silicon or germanium.

In the light-emitting diode of the third embodiment, as functional substrate 31, silicon or germanium is preferable. Since the materials are hard to corrode, humidity resistance can be improved.

As the reflection layer 23, for example, silver (Ag), aluminium (Al), gold (Au) or alloy thereof may be used. Since these materials have high reflectance, the reflectance of the reflection layer 23 can be 90% or more.
The functional substrate 31 may include a combination of bonding reflection layer 23 with a cheap substrate (layer) such as silicon or germanium by using eutectic metal such as AuIn, AuGe, or AuSn. Since AuIn has low bonding temperature, and small difference in thermal expansion coefficient from the light-emitting section in particular, it is the most preferable combination to bond the cheapest silicon substrate (a silicon layer) with AuIn.
For example, as functional substrate 31, it is more preferable from the viewpoint of stability of quality to insert a layer made from a metal having a high melting point such as titanium (Ti), tungsten (W) or platinum (Pt) so that current diffusion layer, reflection layer metal and eutectic metal do not diffuse mutually.

### Light-emitting Diode (Third Embodiment)

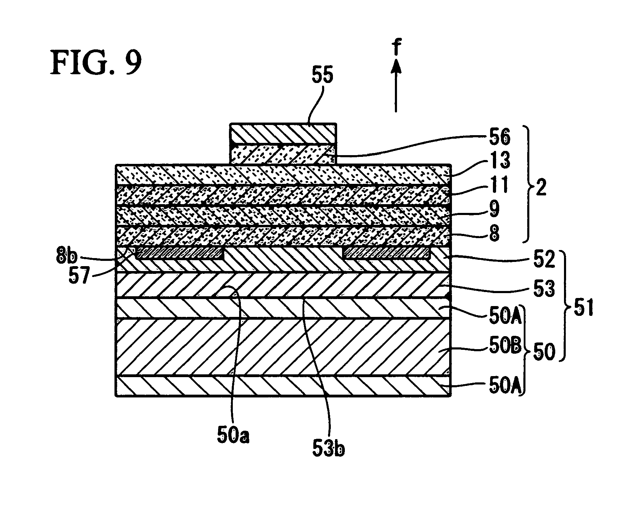

FIG. 9 is diagram for describing the light-emitting diode related to the third embodiment to which the invention is applied.
The light-emitting diode of the third embodiment includes: a light-emitting section, which includes an activity layer 10, wherein the activity layer 10 emits infrared light and includes a multilayer including a well layer which includes a composition expressed by the composition formula of (AlₓGa₁₋ₓ) As (0 ≤X≤1) and a barrier layer; a current diffusion layer 8; and a functional substrate 51 which includes a reflection layer 53 having reflection index of 90 % or more at the emitting wavelength and a metal substrate 50, the functional substrate 51 is bonded to the current diffusion layer 8.

As light-emitting diode of the third embodiment, the point that the functional substrate includes metal substrate is different from that of the light-emitting diode of the second embodiment.
Since the metal substrate has a high heat dissipation characteristic, using the metal substrate in the light-emitting diode not only can contribute to emit light in high brightness, but also can increase the lifetime of the light-emitting diode.
From the viewpoint of heat dissipation characteristics, it is preferable to use metal substrate made from a metal having a coefficient of thermal conductivity of 130 W/m•K or more. For example, the metal having the coefficient of thermal conductivity of 130 W/m•K or more is molybdenum (138 W/m•K) and tungsten (174W/m•K).

As shown in FIG. 9, the compound semiconductor layer 2 includes an activity layer 10, a first clad layer (lower part clad) 9 and a second clad layer (upper part clad) 11 between both of which the activity layer 10 is inserted through a guide layer (not shown), a current diffusion layer 8 below the first clad layer (lower part clad) 9, a first electrode 55 above the second clad layer (upper part clad) 11, and a contact layer 56 having about the same size in planar view.
A functional substrate 51 includes a second electrode 57 on lower surface 8b of the current diffusion layer 8, a reflection structure obtained by laminating a transparent conducting layer 52 and reflection layer 53 in order to cover the second electrode 57, and a metal substrate 50. The surface 53b of the reflection layer 53 opposite to the semiconductor compound layer is bonded to the bonding surface 50a of the metal substrate 50.

As the reflection layer 53, for example, a metal such as copper, silver, gold, aluminium or alloy thereof may be used. Since these materials have high reflectance, the reflectance of the reflection layer 53 can be 90% or more. Since reflection layer 53 is formed, light emitted from the activity layer 10 is reflected in front direction f by the reflection layer 53, and the light extraction efficiency in front direction f can be improved. As a result, a light-emitting diode having higher intensity can be produced.

As the reflection layer 53, multilayer including Ag, a Ni/Ti barrier layer, and Au-typed eutectic metal (bonding metal) in the above order from the side of transparent conducting layer 52 is preferable.
The bonding metal is a metal having low electric resistance and low melting point. The metal substrate can be bonded without giving the compound semiconductor layer 2 heat stress by using the metal for bonding.
As the bonding metal, Au-typed eutectic metal having a low melting point and having chemical stability may be used. As Au-typed eutectic metal, for example, an eutectic composition (As Au-typed eutectic metal) of alloy such as AuSn, AuGe, AuSi can be used.
In addition, it is preferable to add a metal such as titanium, chromium, tungsten in the bonding metal. As a result, the metal such as titanium, chromium, tungsten can prevent, as barrier metal, impurity in the metal substrate from diffusing into the reflection layer 53 and depressing the reaction.

Transparent conducting layer 52 includes ITO layer and IZO layer. A reflection structure may include the reflection layer 53 only.
In addition, as a substitution for the transparent conducting layer 52, or combination with the transparent conducting layer 52, a so-called cold mirror which utilizes refractive index difference of transparent materials may be put together with the reflection layer 53. For example, a multilayer film of oxidation titanium film or silicon oxide, white alumina and AIN may be used.

As the metal substrate 50, plural metal layers may be used.
It is preferable that two kinds of metal layers are laminated alternately to form the metal substrate.
Particularly, it is preferable that the layer number of these two kinds of metal layers is an odd number.

In this case, from the viewpoint of warping and cracking of the metal substrate, when a second metal layer 50B uses a material having a smaller coefficient of thermal expansion than that of compound semiconductor layer 2, it is preferable that a first metal layer 50A uses a material having larger coefficient of thermal expansion than that of compound semiconductor layer 2. Since the coefficient of thermal expansion of the whole metal substrate is similar to coefficient of thermal expansion of the compound semiconductor layer, warping and cracking of the metal substrate when bonding the compound semiconductor layer can be repressed. As a result, manufacturing yield of the light-emitting diode can be improved. When second a second metal layer 50B uses a material having larger coefficient of thermal expansion than that of the compound semiconductor layer 2, it is preferable that a first metal layer 50A uses a material having a smaller coefficient of thermal expansion than that of compound semiconductor layer 2. Since the coefficient of thermal expansion of the whole metal substrate is similar to coefficient of thermal expansion of the compound semiconductor layer, warping and cracking of the metal substrate when bonding the compound semiconductor layer can be repressed. As a result, manufacturing yield of the light-emitting diode can be improved.
From the viewpoint of above, two kinds of metal layers may be used as either the first metal layer or the second metal layer.
As two kinds of metal layers, for example, a combination between a metal layer made from silver (coefficient of thermal expansion = 18.9ppm/K), copper(coefficient of thermal expansion = 16.5ppm/K) gold(coefficient of thermal expansion = 14.2ppm/K) aluminium (coefficient of thermal expansion = 23.lppm/K), nickel (coefficient of thermal expansion = 13.4ppm/K) and alloy thereof; and a metal layer made from molybdenum (coefficient of thermal expansion = 5.1 ppm/K), tungsten (coefficient of thermal expansion = 4.3ppm/K), chromium (coefficient of thermal expansion = 4.9ppm/K) and alloy thereof can be used.
A metal substrate having three layers of Cu/Mo/Cu is preferable. From the above view point, a similar effect is provided with the metal substrate having three layers of Mo/Cu/Mo. However, since the metal substrate having three layers of Cu/Mo/Cu has a structure in which Mo having strong mechanical strength is surround by Cu which is easy to process, it is easier to be processed than that of the metal substrate having three layers of Mo/Cu/Mo.

As the coefficient of thermal expansion of the whole metal substrate, for example, metal substrate having three layers of Cu (30µm) /Mo (25µm) /Cu (30µm) is 6.1 ppm/K, and the metal substrate having three layers of Mo (25µm) /Cu (70µm) /Mo (25µm) is 5.7ppm/K,

In addition, from the viewpoint of heat dissipation, it is preferable that a metal layer of the metal substrate is made from materials having high heat-conductivity. As a result, since heat dissipation ability of metal substrate is improved, not only the light-emitting diode can emit light in high brightness, but also the light-emitting diode having a long lifetime can be obtained.
For example, it is preferable that silver (heat-conductivity = 420W/m•K), copper (heat-conductivity = 398W/m•K), gold (heat-conductivity = 320W/m•K), aluminium (heat-conductivity = 236W/m•K), molybdenum (heat-conductivity = 138W/m•K), or tungsten (heat-conductivity = 174W/m•K), and an alloy thereof be used.
It is more preferable that the coefficient of thermal expansion of the materials of the metal layers is approximately equal to the coefficient of thermal expansion of the compound semiconductor layer. It is particularly preferable that the material of the metal layer has the coefficient of thermal expansion which is within ± 1.5ppm/K of the coefficient of thermal expansion of the compound semiconductor layer. Since the stress, which is generated by heat when metal substrate is bonded with the compound semiconductor layer, to light-emitting section can be lowered, crack of metal substrate, which is generated by heat when bonding the compound semiconductor layer, can be repressed. As a result, manufacturing yield of the light-emitting diode can be improved.
As a heat-conductivity of the whole metal substrate, for example, the heat-conductivity of metal substrate having three layers of Cu (30µm) /Mo (25µm) /Cu (30µm) is 250W/m•K and the heat-conductivity of metal substrate having three layers of Mo (25µm) /Cu (70µm) /Mo (25µm) is 220W/m•K.

### EXAMPLES

Hereinafter, the effects of the invention will be specifically described using Examples. In addition, the invention is not limited to these Examples.

In accordance with the Examples, an example of producing a light-emitting diode of the present invention is described concretely. After the light-emitting diode was obtained, for characteristic evaluation, a light-emitting diode lamp in which a light-emitting diode chip is mounted on a substrate was manufactured.

### Example 1

The light-emitting diode of Example 1 is an example of the first embodiment.
At first, an epitaxial wafer was manufactured by sequentially laminating compound semiconductor layers on a GaAs substrate made of a Si-doped n-type GaAs single crystal. In the GaAs substrate, a plane inclined by 15° in a (0-1-1) direction from a (100) plane was set to be a growth plane and a carrier concentration was set to be 2x10¹⁸ cm⁻³. The thickness of GaAs substrate was 0.5µm. The compound semiconductor layers are an n-type buffer layer made of Si-doped GaAs, an n-type contact layer made of Si-doped (Al_{0.7}Ga_{0.3}) _{0.5}In_{0.5}P, an n-type upper clad layer made of Al_{0.7}Ga_{0.3}As, well layer/barrier layer composed of 20 pairs of Al_{0.18}Ga_{0.82}As/Al_{0.3}Ga_{0.7}As, a p-type lower clad layer made of Al_{0.7}Ga_{0.3}As, and a current diffusion layer made of Mg-doped p-type GaP.

In this example, the epitaxial wafer was formed by making the compound semiconductor layers epitaxially grow in the GaAs substrate having a diameter of 76 mm and a thickness of 350 µm with the use of a low-pressure metal-organic chemical vapor deposition apparatus (MOCVD apparatus). When making epitaxial growth layers grow, as a raw material of a group III constituent element, trimethylaluminum ((CH₃)₃Al), trimethylgallium ((CH₃)₃Ga), and trimethylindium ((CH₃)₃In) were used. Further, as a doping material of Mg, bis-cyclopentadienyl magnesium (bis-(C₅H₅)₂Mg) was used. Further, as a doping material of Si, disilane (Si₂H₆) was used. Further, as a raw material of a group V constituent element, phosphine (PH₃) and arsine (AsH₃) were used. Further, as the growth temperature of each layer, the current diffusion layer made of p-type GaP was grown at 750 °C. In each of the other layers, growth was performed at 700 °C.

In the buffer layer made of GaAs, a carrier concentration was set to be about 2x10¹⁸ cm⁻³ and a layer thickness was set to be about 0.5 µm. In the contact layer, a carrier concentration was set to be about 2x10¹⁸ cm⁻³ and a layer thickness was set to be about 3.5 µm. In the upper clad layer, a carrier concentration was set to be about 1x10¹⁸ OIS cm⁻³ and a layer thickness was set to be about 0.5 µm. The well layer was set to be undoped Al_{0.18}Ga_{0.82}As having a layer thickness of about 17 nm. The barrier layer was set to be undoped Al_{0.3}Ga_{0.7}As having a layer thickness of about 19 nm. Further, a well layer and a barrier layer were alternately laminated in 20 pairs. In the lower clad layer, a carrier concentration was set to be about 8x10¹⁷ cm⁻³ and a layer thickness was set to be about 0.5 µm. In the current diffusion layer made of GaP, a carrier concentration was set to be about 3x10¹⁸ cm⁻³ and a layer thickness was set to be about 9 µm.

Next, the current diffusion layer was mirror-finished by polishing it up to a region which reached a depth of about 1 µm from the surface. As a result mirror finishing, the roughness of the surface was made to be 0.18 nm. On the other hand, a functional substrate made of n-type GaP which is attached to the mirror-polished surface was prepared. As the functional substrate for attachment, a single crystal in which Si was added thereto such that a carrier concentration became about 2x10¹⁷ cm⁻³, and a plane orientation was set to be (111), was used. Further, the diameter of the functional substrate was 76 mm and the thickness was 250 µm. The surface of the functional substrate was finished to have a root-mean-square value (rms) of 0.12 nm by polishing it into a mirror surface before it was bonded to the current diffusion layer.

Next, the functional substrate and the epitaxial wafer were loaded into a general semiconductor material attachment apparatus and the inside of the apparatus was evacuated until a vacuum of 3x10⁻⁵ Pa was obtained.

Next, the surfaces of both the functional substrate and the current diffusion layer were irradiated with an Ar beam neutralized by collision of electrons over three minutes. Thereafter, in the attachment apparatus in which a vacuum was maintained, the surfaces of the functional substrate and the current diffusion layer were bonded to each other at room temperature by overlapping the surfaces over each other and then applying a load thereto such that pressure on each surface became 50 g/cm². In this way, a bonded wafer was formed.

Next, the GaAs substrate and the GaAs buffer layer were selectively removed from the bonded wafer by an ammonia-based etchant. Next, AuGe, Ni alloy having a thickness of 0.5 µm Pt having a thickness of 0.2 µm and Au having a thickness of 1 µm were formed on the surface of the contact layer as the first electrode by a vacuum deposition method. Thereafter, an n-type ohmic electrode, as a first electrode, was formed by performing patterning with the use of general photolithography means. The main light extraction surface, which was obtained by removing GaAs substrate, was then rough treated.

Next, the epitaxial layer in an area to form a p-type ohmic electrode was selectively removed, thereby exposing the current diffusion layer. On the exposed surface, the p-type ohmic electrode was formed by a vacuum deposition method such that AuBe became 0.2 µm and Au became 1 µm. Thereafter, the low-resistance p-type and n-type ohmic electrodes were formed by carrying out alloying by performing a thermal treatment at 450 °C and for 10 minutes.

Next, from the backside of the functional substrate, the functional substrate is processed by performing a V-shaped groove in the surface in which the third electrode is not formed by using dice cutting saw, wherein the V-shaped groove has an inclined plane having an angle a of 70 degrees and an perpendicular plane having a thickness of 80µm.. Secondly, the substrate was cut from the side of compound semiconductor layer in an interval of 350 µm by using dice cutting saw, and chips were formed. And then, a crush layer and fouling, which were yield during the dice cutting, were etched with a mixed solution of sulfuric acid and hydrogen peroxide. And then, the light-emitting diode of Example 1 was obtained.

Twenty pieces of the light-emitting diode lamps each having the light-emitting diode chip of Example 1 manufactured as described above mounted on a mount substrate were assembled. The light-emitting diode lamp was produced by keeping a mount substrate by a die-bonder (mount) , wire-bonding a n-type ohmic electrode of the light-emitting diode and a n-electrode terminal of the mount substrate by a gold wire, wire-bonding the p-type ohmic electrode to a p-electrode terminal by a gold wire, and then performing sealing with a general epoxy resin.

The evaluation results of the characteristics of the light-emitting diode (the light-emitting diode lamp) are shown in Table 1. As shown in Table 1, when an electric current flowed between the n-type and p-type ohmic electrodes, infrared light having a peak wavelength of 730 nm was emitted. A forward voltage (V_{F}) was about 2.0 V, because of a low resistance in the bonded interface between the current diffusion layer constituting the compound semiconductor layer and the functional substrate, and an excellent ohmic characteristic of each ohmic electrode when an electric current of 20 mA flowed in a forward direction. A light emitting output when a forward current was set to be 20 mA was 13 mW.
Moreover, under the condition of high temperature and high humidity of 60 °C and 90%, a power-on test (20 mA power-on) was performed for 1000 hours, and an output survival rate (reliability) of emitting light output was obtained and shown in the following Table 1.

**Table 1**

| | Device Structure | Substrate | λ_{P} (nm) | Po (20 mA) | V_{F} (20 mA) | Reliability Po: % | Reliability V_{F}: % |
|---|---|---|---|---|---|---|---|
| Example 1 | Transparent | GaP | 730 | 13 | 2.0 | 96 | 99 |
| Example 2 | Reflection | Si | 730 | 10 | 1.9 | 96 | 99 |
| Example 3 | Reflection | Cu/Mo/Cu | 730 | 10.2 | 1.9 | 95 | 99 |
| Example 4 | Transparent | GaP | 720 | 13 | 1.9 | 95 | 99 |
| Example 5 | Reflection | Si | 720 | 10 | 1.9 | 95 | 99 |
| Example 6 | Transparent | GaP | 760 | 14 | 2.0 | 97 | 100 |
| Example 7 | Reflection | Si | 760 | 11 | 1.9 | 96 | 100 |
| Example 8 | Transparent | GaP | 725 | 13 | 1.9 | 95 | 99 |
| Example 9 | Transparent | GaP | 755 | 13.5 | 2.0 | 96 | 100 |
| Comparative example | Liquid phase epitaxial | AlGaAs | 730 | 55 | 1.9 | 83 | 105 |

### Example 2

A light-emitting diode of Example 2 is shown in FIGs. 8 A and 8B. Light-emitting diode of example 2 is the combination bonding a functional substrate to a reflecting surface. The other formation of the light-emitting section was the same as that of Example 1.

On the surface of current diffusion layer 8, eight electrodes 21 made from AuBe/Au alloy at dot shape having a thickness of 0.2 µm and a diameter of 20 µm, were placed in the same interval and at a distance of 50µm from the end of the light extraction surface.
Next, the ITO layer 22 as a transparent conducting layer having a thickness of 0.4µm was formed by a sputtering method. Layer 23 made from silver alloy /Ti/Au in a thickness of 0.2µm/0.1µm/1µm was formed as the reflecting surface 23.

On the other hand, layer 32 made from Ti/Au/In in a thickness of 0.1µm /0.5µm /0.3µm was formed on the surface of silicon substrate 31. Layer 33 made from Ti/Au in a thickness of 0.1µm/0.5µm was formed on backside of silicon substrate 31. The Au surface of the light-emitting diode wafer and the In surface of the silicon substrate are overlapped, and pressurized under a temperature of 320°C and pressure of 500g/cm², as a result, the functional substrate was bonded to the light-emitting diode wafer.

After GaAs substrate is removed, on the surface of contact layer 16, a filament ohmic electrode 25a made from AuGe/Au, having a width of 5µm and thickness of 0.5µm was formed. And then a pn ohmic electrode were performed by an alloying-process of heat-treatment under 420°C for five minutes. And then, a Au bonding electrode 25 having a diameter of 90µm was formed.

Next, the surface of the contact layer 16 was rough-processed.
After removing semiconductor layer, reflection layer of segment, and eutectic metal on the section to be dice cut, a silicon substrate was cut in 350µm pitch to obtain a regular square by using a dice cutting saw.

The evaluation results of the characteristics of this light-emitting diode (light-emitting diode lamp) are shown in Table 1.
As shown in Table 1, an infrared light having peak wavelength 730nm was emitted when electric current flowed between electrodes of upper and downer sides. A forward voltage (V_{F}) was about 1.9 V because of a low resistance in the bonded interface between the current diffusion layer constituting the compound semiconductor layer and the functional substrate, and an excellent ohmic characteristic of each ohmic electrode when an electric current of 20 mA flowed in a forward direction. A light emitting output when a forward current was set to be 20 mA was 10 mW.
Moreover, under the condition of high temperature and high humidity at 60 °C and 90%, a power-on test (20 mA power-on) was performed for 1000 hours, and a survival rate (reliability) of emitting light output was obtained and shown in the following Table 1.

### Example 3

The light-emitting diode of Example 3 is an example of the third embodiment, in which a current diffusion layer is bonded with a functional substrate including a reflection layer and a metal substrate. As shown in FIG. 9, a light-emitting diode of Example 3 is described.

At first, a metal substrate was produced. It was produced by preparing two approximately flat Cu boards of thickness 10µm and one approximately flat Mo board of thickness 75µm, inserting the Mo board into the two pieces of Cu boards to overlap the three boards, placing them into a pressure-applying apparatus, and applying load to the metal boards at high temperature in direction of thickness. As a result, a metal substrate including three layers of Cu (10µm) /Mo (75µm) /Cu (10µm) was produced.

The compound semiconductor layer was formed by the same method of Example 1, except that between buffer layer and a contact layer an etch stop layer made from Si-doped (Al_{0.5}Ga_{0.5}) _{0.5}In_{0.5}P with a thickness of 0.5 µm was formed.
On the surface 8b of current diffusion layer 8, second electrodes 57 were formed in the same interval of 60µm by laminating Au having a thickness of 0.2µm on AuBe having a thickness of 0.4µm, wherein the second electrodes 57 were a columnar shape having a diameter of 20µm.
Next, an ITO layer 52 as a transparent conducting layer was formed by a sputtering method in a thickness of 0.8µm to cover second anode 57.
Next, on the ITO layer 52, a reflection coating 53 was produced by forming a layer made from silver (Ag) alloy having a thickness of 0.7µm by vaporization method, and then, forming a layer made from nickel (Ni) / Titanium (Ti) having a thickness of 0.5µm, and then and a layer made from gold (Au) having a thickness of 1µm.
A bonding structure was formed by placing the structure made of ITO layer 52 and reflection coating 53a on the current diffusion layer 8 of the compound semiconductor layer and the metal substrate so as to make them face each other; transferring them into a vacuum chamber; bonding them at at 400°C by using a 500kg load.
And then, from a bonding structure, GaAs substrate and the buffer layer which is used as a growth substrate of the compound semiconductor layer was removed by ammonia type etchant selectively. The etching stop layer was removed by HCI type etchant selectively.
Next, on a contact layer, a conducting layer for a first electrode was formed using vacuum deposition method by forming a AuGe layer having a thickness of 0.15µm, and then forming a Ni layer having a thickness of 0.05pm, and moreover forming Au layer having a thickness of 1µm more. By using a photolithography method, a first electrode 55 having a thickness 3 µm and diameter of 100µm was produced by patterning the conducting layer for an electrode to the shape of circle in planar view.
The contact layer 56 was formed by etching a section of contact layer except for the section below the first electrode, by using ammonia type etchant and using the first electrode as mask.
After removing the semiconductor layer, a reflection layer of segment, and eutectic metal on the section to be dice cut, a silicon substrate was cut at a 350µm pitch to obtain a regular square by using a dice cutting saw.

The evaluation results of the characteristics of this light-emitting diode (light-emitting diode lamp) are shown in Table 1.
As shown in Table 1, an infrared light having peak wavelength 730nm was emitted when electric current flowed between electrodes of upper and downer sides. A forward voltage (V_{F}) was about 1.9 V because of a low resistance in the bonded interface between the current diffusion layer constituting the compound semiconductor layer and the functional substrate and an excellent ohmic characteristic of each ohmic electrode when an electric current of 20 mA flowed in a forward direction. A light emitting output when a forward current was set to be 20 mA was 10.2 mW.
Moreover, under the condition of high temperature and high humidity at 60°C and 90RH%, 20 mA power-on tests of twenty of the lamps were performed.
The average of output survival rate after 1000 hours later was 95%. There was no variation of V_{F}, and it was 99%.

### Example 4

The light-emitting diode of Example 4 is an example of the first embodiment, and was produced under the same condition as that of Example 1, except that Al composition of well layer was X₁ =0.20 and the Al composition of a barrier layer having composition formula (Alₓ₂Ga₁₋ₓ₂) As (0 ≤X_{2≤}1) was X₂ =0.35; and that is, the light-emitting section was changed to a well layer / barrier layer made from a pair of Al_{0.2}Ga_{0.8}As / Al_{0.35}Ga_{0.65}As in order to obtain emitting light peak wavelength of 720nm.
The evaluation results of the characteristics of this light-emitting diode (light-emitting diode lamp) are shown in Table 1. Red light having peak wavelength 720nm was emitted, the emitting light output (Pₒ), the forward voltage (VF₎, the average of output survival rate, the variation of forward direction voltage were 13mW, 1.9V, 95%, 99%, respectively.

### Example 5

The light-emitting diode of Example 5 is an example of the second embodiment, and was produced under the same condition as that of Example 2, except that Al composition of well layer was X₁ =0.20 and Al composition of a barrier layer having composition formula (Alₓ₂Ga₁₋ₓ₂) As (0 ≤X_{2≤}1) was X₂ =0.35; and that is, the light-emitting section was changed to a well layer / barrier layer made from a pair of Al_{0.2}Ga_{0.8}As / Al_{0.35}Ga_{0.65}As in order to obtain emitting light peak wavelength of 720nm. The change of Al composition of a barrier layer from X₂ =0.30 to X₂ =0.35 did not affect the emitting light peak wavelength.
The evaluation results of the characteristics of this light-emitting diode (light-emitting diode lamp) are shown in Table 1. Red light having a peak wavelength 720nm was emitted, the emitting light output (Pₒ), the forward voltage (VF₎, the average of output survival rate, the variation of forward direction voltage were 10mW, 1.9V, 95%, 99%, respectively.

### Example 6

The light-emitting diode of Example 6 is an example of the first embodiment, and was produced under the same condition as that of Example 1, except that Al composition of the well layer was X₁ =0.13 and Al composition of a barrier layer having composition formula (Alₓ₂Ga₁₋ₓ₂) As (0 ≤X_{2≤}1) was X₂ =0.3; and that is, the light-emitting section was changed to a well layer / barrier layer made from a pair of Al_{0.13}Ga_{0.87}As / Al_{0.3}Ga₀.₇As in order to obtain an emitting light peak wavelength of 760nm.
The evaluation results of the characteristics of this light-emitting diode (light-emitting diode lamp) are shown in Table 1. Infrared light having peak wavelength 760nm was emitted, the emitting light output (Pₒ), the forward voltage (V_{F}), the average of output survival rate, the variation of forward direction voltage were 14mW, 2.0V, 96%, 100%, respectively.

### Example 7

The light-emitting diode of Example 7 is an example of the second embodiment, and was produced under the same condition as that of Example 2, except that Al composition of well layer was X₁ =0.13 and Al composition of a barrier layer having composition formula (Al_{X2}Ga_{1-X2}) As (0 ≤X_{2≤)}) was X₂ =0.3; and that is, the light-emitting section was changed to a well layer / barrier layer made from a pair of Al_{0.3}Ga_{0.87}As / Al_{0.3}Ga_{0.7}As in order to obtain emitting light peak wavelength of 760nm.
The evaluation results of the characteristics of this light-emitting diode (light-emitting diode lamp) are shown in Table 1. An infrared light having peak wavelength 760nm was emitted, the emitting light output (Pₒ), the forward voltage (V_{F}),the average of output survival rate, the variation of forward direction voltage were 11mW, 1.9V, 96%, 100%, respectively.

### Example 8

The light-emitting diode of Example 8 is an example of the first embodiment, and was produced under the same condition as that of Example 1, except that Al composition of well layer was X =0.19 and Al composition of a barrier layer having composition formula (Alₓ₂Ga₁₋ₓ₂) As (0 ≤X_{2≤}1) was X₂ =0.35; and that is, the light-emitting section was changed to a well layer / barrier layer made from a pair of Al_{0.19}Ga_{0.81}As / Al_{0.35}Ga_{0.65}As in order to obtain emitting light peak wavelength of 725nm.
The evaluation results of the characteristics of this light-emitting diode (light-emitting diode lamp) are shown in Table 1. An infrared light having peak wavelength 725nm was emitted, the emitting light output (Pₒ), the forward voltage (V_{F}), the average of output survival rate, the variation of forward direction voltage were l3mW, 1.9V, 95%, 99%, respectively.

### Example 9

The light-emitting diode of Example 9 is an example of the first embodiment, and was produced under the same condition as that of Example 1, except that Al composition of well layer was X₁ =0.15 and Al composition of a barrier layer having composition formula (Alₓ₂Ga_{1-X2}) As (0 ≤X≤1) was X₂ =0.30; and that is, the light-emitting section was changed to a well layer / barrier layer made from a pair of Al_{0.14}Ga_{0.86}As / Al_{0.3}Ga_{0.7}As in order to obtain emitting light peak wavelength of 755nm.
The evaluation results of the characteristics of this light-emitting diode (light-emitting diode lamp) are shown in Table 1. An infrared light having peak wavelength 755nm was emitted, the emitting light output (Pₒ), the forward voltage (V_{F}), the average of output survival rate, the variation of forward direction voltage were 13.5mW, 2.0V, 96%, 100%, respectively.

### Comparative Example 1

A light-emitting diode of Comparative example 1 was formed by a liquid-phase epitaxial method that is known in prior art. The light-emitting diode of Comparative example 1 is a substrate-removing-typed light-emitting diode having a light-emitting section of a double hetero structure having an Al_{0.2}Ga_{0.8}As light-emitting layer which was formed on a GaAs substrate.

In the manufacturing of the light-emitting diode of Comparative example 1, specifically, a n-type upper clad layer made of Al_{0.7}Ga_{0.3}As and having a thickness of 20 µm, an undoped light-emitting layer made of Al_{0.2}Ga_{0.8}As and having a thickness of 2 µm, an p-type lower clad layer made of Al_{0.7}Ga_{0.3}As and having a thickness of 20 µm, and an p-type thick-film layer made of Al_{0.7}Ga_{0.3}As transparent to the luminescence wavelength and having a thickness of 120 µm were formed on a n-type GaAs single crystal substrate having a (100) plane by a liquid phase epitaxial method. After the epitaxial growth, the GaAs substrate was removed. Next, a n-type ohmic electrode having a diameter of 90 µm was formed on the surface of the n-type AlGaAs. Next, p-type ohmic electrodes each having a diameter of 15 µm was formed at intervals of 80 µm on the back surface of the p-type AlGaAs. Next, after cutting was performed at intervals of 350 µm by a dicing saw, a light-emitting diode chip of Comparative example 1 was manufactured by removing fractured layers by etching and rough-processing surface or side face.

The evaluation results of the characteristics of a light-emitting diode lamp in which the light-emitting diode of Comparative example 1 is mounted are shown in Table 1. As shown in Table 1, when an electric current flowed between the n-type and p-type ohmic electrodes, infrared light having a peak wavelength of 730 nm was emitted. Further, forward voltage (V_{F}) when an electric current of 20 mA flowed in a forward direction was about 1.9 V. Further, a light emitting output when a forward current was set to be 20 mA was 5 mW. In addition, any samples of comparative example 1 had lower output than Examples of the present invention.
Moreover, under the condition of high temperature and high humidity at 60°C and 90RH%, 20 mA power-on tests of twenty of the lamps were performed. The average of output survival rate after 1000 hours later was 83%. And Variation of V_{F} was 105%.
As for the comparative example, decrease of output and increase of V_{F} were observed. In that case, a surface, having high concentration Al, of light-emitting diode was oxidized (corrosion), as a result, light transmission was inhibited, and resistance increased.

### INDUSTRIAL APPLICABILITY

The light-emitting diode of the present invention can emits infrared light in high efficiency, and can be used as higher output light-emitting diode products, such as a light source of plant upbringing application, in comparison with the LED of AlGaAs produced by liquid phase epitaxial method. In addition, it may be used as a LED product with high output instead of conventional LED made of AlGaAs light emitting layer.

### DENOTATION OF REFERENCE NUMERALS

- 1...: light-emitting diode
- 2...: compound semiconductor layer
- 3...: functional substrate
- 3a...: perpendicular plane
- 3b...: inclined plane
- 4...: n type ohmic electrode (the first electrode)
- 5...: p type ohmic electrode (the second electrode)
- 6...: the third electrode
- 7...: light-emitting section
- 8...: current diffusion layer
- 9...: lower clad layer
- 10...: light-emitting (activity) layer
- 11...: upper clad layer
- 12...: well layer
- 13...: barrier layer
- 14...: GaAs substrate
- 15...: buffer layer
- 16...: contact layer
- 20...: light-emitting diode
- 21...: electrode
- 22...: transparent conducting layer
- 23...: reflection layer
- 25...: bonding electrode
- 30...: silicon substrate
- 31...: functional substrate
- 41...: light-emitting diode lamp
- 42...: mount substrate
- 43...: n-electrode terminal
- 44...: p-electrode terminal
- 45,46...: gold wires
- 47...: epoxy resin
- a ...: Angle between the inclined plane and the plane parallel to light-emitting surface
- 50...: metal substrate
- 51...: functional substrate
- 52...: transparent conducting layers
- 53...: reflection layer
- 55...: the first electrode
- 56...: contact layer
- 57...: the second electrode

## Claims

1. A light-emitting diode comprising:
a light-emitting section, which comprises an activity layer, wherein the activity layer emits infrared light and comprises a multilayer comprised of
a well layer which comprises a composition expressed by the composition formula of (AlₓGa₁₋ₓ) As (0 ≤X≤1) and
a barrier layer;
a current diffusion layer formed on the light-emitting section; and
a functional substrate bonded to the current diffusion layer.

2. The light-emitting diode according to Claim 1, wherein the functional substrate is transparent at an emitting wavelength.

3. The light-emitting diode according to Claim 1, wherein the functional substrate comprises GaP, sapphire or SiC.

4. The light-emitting diode according to Claim 1, wherein the side face of the functional substrate comprises
a perpendicular plane which is close to the light-emitting section, the perpendicular plane is perpendicular to the main light-extraction surface, and
an inclined plane which is far to the light-emitting section, the inclined plane is inclined inside to the main light-extraction surface.

5. The light-emitting diode according to Claim 4, wherein the inclined plane comprises a rough surface.

6. A light-emitting diode comprising:
a light-emitting section, which comprises an activity layer, wherein the activity layer emits infrared light and comprises a multilayer comprised of
a well layer which comprises a composition expressed by the composition formula of (Al_{X}Ga_{1-X}) As (0 ≤X≤1) and
a barrier layer;
a current diffusion layer formed on the light-emitting section; and
a functional substrate which comprises a reflection layer having a reflection index of 90% or more at the emitting wavelength, wherein the reflection layer is formed to face the light-emitting section and the functional substrate is bonded to the current diffusion layer.

7. The light-emitting diode according to Claim 6, wherein the functional substrate comprises a silicon or germanium layer.

8. The light-emitting diode according to Claim 6, wherein the functional substrate comprises a metal substrate.

9. The light-emitting diode according to Claim 8, wherein the metal substrate comprises plural metal layers.

10. The light-emitting diode according to Claim 1, wherein the current diffusion layer comprises GaP.

11. The light-emitting diode according to Claim 1, wherein a composition expressed by the composition formula of the current diffusion layer is (Al_{X}Ga_{1-X}) As (0 ≤X≤0.5).

12. The light-emitting diode according to Claim 1, wherein a thickness of the current diffusion layer is in the range of 0.5 to 20µm.

13. The light-emitting diode according to Claim 1, wherein a first electrode and a second electrode are installed in the side of the main light extraction surface of the light-emitting diode.

14. The light-emitting diode according to Claim 13, wherein the first electrode and the second electrode are ohmic electrodes.

15. The light-emitting diode according to Claim 13, wherein a third electrode is further installed in the back side of the main light extraction surface of the light-emitting diode.

16. A light-emitting diode lamp comprising the light-emitting diode according to Claim 1.

17. A light-emitting diode lamp comprising the light-emitting diode according to Claim 15, wherein the first electrode or the second electrode is connected to the third electrode at an approximate electric potential.

18. An illuminating apparatus comprising plural light-emitting diodes according to Claim 1.
